(19) **Europäisches Patentamt / European Patent Office / Office européen des brevets**

(11) **EP 4 768 974 A1**

(12) **EUROPEAN PATENT APPLICATION**
published in accordance with Art. 153(4) EPC

(43) Date of publication:
**01.07.2026 Bulletin 2026/27**

(21) Application number: **25808183.5**

(22) Date of filing: **23.05.2025**

(51) International Patent Classification (IPC):
**G01R 31/396** (2019.01)    **G01R 31/382** (2019.01)
**G01R 31/374** (2019.01)    **G01R 31/36** (2020.01)
**G06F 18/10** (2023.01)    **G06N 20/00** (2019.01)
**G01R 31/3835** (2019.01)

(52) Cooperative Patent Classification (CPC):
**G01R 31/36; G01R 31/374; G01R 31/382;
G01R 31/3835; G01R 31/396; G06F 18/10;
G06N 20/00**

(86) International application number:
**PCT/KR2025/007015**

(87) International publication number:
**WO 2025/244458 (27.11.2025 Gazette 2025/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **23.05.2024 KR 20240067307
16.04.2025 KR 20250049564**

(71) Applicant: **LG Energy Solution, Ltd.
Seoul 07335 (KR)**

(72) Inventors:
• **LEE, Gyu Rin**
  **Daejeon 34122 (KR)**
• **PARK, Jae Dong**
  **Daejeon 34122 (KR)**
• **CHEON, Jae Yeong**
  **Daejeon 34122 (KR)**
• **LEE, Gyu Yeol**
  **Daejeon 34122 (KR)**

(74) Representative: **BCKIP Part mbB
Landsberger Straße 98
80339 München (DE)**

(54) **BATTERY DIAGNOSIS DEVICE AND METHOD**

(57)    An apparatus for diagnosing a battery includes a communication interface for receiving battery data obtained by applying a current signal to a battery module, and at least one processor for performing error correction to correct an influence of a sensing line related to a structure of the battery module and generating preprocessed data from the battery data, extracting a feature value based on the preprocessed data, and diagnosing whether a state of the battery module is abnormal based on the feature value.

FIG.3

# EP 4 768 974 A1

**Description**

**TECHNICAL FIELD**

CROSS-REFERENCE TO RELATED APPLICATION

This application claims the priority of Korean Patent Application No. 10-2024-0067307 filed on May 23, 2024, in the Korean Intellectual Property Office, and Korean Patent Application No. 10-2025-0049564 filed on April 16, 2025, in the Korean Intellectual Property Office, the disclosure of which is incorporated herein by reference.

Field of the Invention

The present invention relates to an apparatus and method for diagnosing a battery.

**BACKGROUND ART**

In general, research and development on secondary batteries have been actively conducted recently. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. In addition, the scope of use of the lithium ion batteries has expanded to include a power source for electric vehicles, and the lithium ion batteries are attracting attention as a next-generation energy storage medium.
If a defect exists in such a battery, heat or fire may occur during charging and discharging and use, which may result in a safety risk. Therefore, research is being conducted on how to diagnose a battery based on battery data. In particular, there is a need to inspect a battery pack in a short period of time to minimize an operation downtime of a battery-using device and ensure performance and safety thereof, but there is a problem of lack of related technology.

**DISCLOSURE OF THE INVENTION**

**TECHNICAL PROBLEM**

An aspect of the present invention provides an apparatus for diagnosing a battery that can precisely analyze voltage behavior by applying a current signal to a battery module in order to quickly evaluate a state of the battery.
The technical problems of the embodiments disclosed in this document are not limited to the technical problems mentioned above, and other technical problems that are not mentioned may be clearly understood by those skilled in the art from the descriptions below.

**TECHNICAL SOLUTION**

According to an aspect of the present invention, there is provided an apparatus for diagnosing a battery including a communication interface for receiving battery data acquired by applying a current signal to a battery module, and at least one processor for performing error correction to correct an influence of a sensing line related to a structure of the battery module and generating preprocessed data from the battery data, extracting a feature value based on the preprocessed data, and diagnosing a state of the battery module based on the feature value.
The at least one processor may group the battery data according to a sensing line shape of the battery module to generate a plurality of sensing line group data, and generate the preprocessed data by correcting a difference between the sensing line group data with a correction value.
The at least one processor may derive the correction value at a point where a difference value between the sensing line group data is maximum, and correct a difference between the sensing line group data with the correction value.
The at least one processor may derive the correction value based on an average value of correction target data included in the plurality of sensing line group data and an average value of the remaining data.
The at least one processor may derive a value obtained by excluding an average value of the average value of the correction target data and the average value of the remaining data from the average value of the correction target data as the correction value, and may correct the difference with the correction value.
The at least one processor may diagnose the state of the battery module by applying a weight determined based on the structure of the battery module to the feature value.

The at least one processor may calculate a degree of proximity of a plurality of battery cells included in the battery module, and diagnose the state of the battery module by applying the weight differently to the feature value based on the degree of proximity.

The at least one processor may diagnose the state of the battery module by applying the weight differently to the feature value based on relative locations of power lines connected to the plurality of battery cells and the battery module.

The at least one processor may generate a trend line obtained by removing an outlier based on a correlation between a voltage value included in the battery data and the feature value, and diagnose the state of the battery module based on the trend line.

The at least one processor may derive a distance value between a feature value for each battery cell included in the battery module and the trend line, and diagnose a battery cell whose distance value is greater than or equal to a preset reference value as abnormal.

According to another aspect of the present invention, there is provided a method of diagnosing a battery including receiving battery data acquired by applying a current signal to a battery module, performing error correction to correct an influence of a sensing line related to a structure of the battery module and generating preprocessed data from the battery data, extracting a feature value based on the preprocessed data, and diagnosing a state of the battery module based on the feature value.

The extracting of the feature value may include applying linear transformation to the preprocessed data to acquire linearly transformed data, and extracting the feature value from the linearly transformed data.

The generating of the preprocessed data may include grouping the battery data according to a sensing line shape of the battery module to generate a plurality of sensing line group data, and generating the preprocessed data by correcting a difference between the sensing line group data with a correction value.

The correcting of the difference between the sensing line group data may include deriving the correction value at a point where a difference value between the sensing line group data is maximum, and correcting a difference between the sensing line group data with the correction value.

The deriving of the correction value may include deriving the correction value based on an average value of correction target data included in the plurality of sensing line group data and an average value of the remaining data.

The deriving of the correction value may include deriving a value obtained by excluding an average value of the average value of the correction target data and the average value of the remaining data from the average value of the correction target data as the correction value.

The diagnosing of the state of the battery module may include diagnosing a state of the battery module by applying a weight determined based on the structure of the battery module to the feature value.

The diagnosing of the state of the battery module may include calculating a degree of proximity of a plurality of battery cells included in the battery module, and diagnosing the state of the battery module by applying the weight equally to the feature value based on the degree of proximity.

The diagnosing of the state of the battery module may include diagnosing the state of the battery module by applying the weight differently to the feature value based on a relative location of a power line connected to the battery module.

The diagnosing of the state of the battery module may include generating a trend line obtained by removing an outlier based on a correlation between a voltage value included in the battery data and the feature value, and diagnosing the state of the battery module based on the trend line.

The diagnosing of the state of the battery module may include deriving a distance value between a feature value for each battery cell included in the battery module and the trend line, and diagnosing a battery cell whose distance value is greater than or equal to a preset reference value as abnormal.

## ADVANTAGEOUS EFFECTS

According to the apparatus for diagnosing the battery according to an embodiment, the reliability of the battery system can be improved by quickly diagnosing the state of the battery, and efficiency can be increased by reducing the time associated with battery diagnosis.

## BRIEF DESCRIPTION OF THE DRAWINGS

FIG. 1 is a block diagram showing a general battery system including an apparatus for diagnosing a battery according to an embodiment;

FIG. 2 is a block diagram showing a configuration of an apparatus for diagnosing a battery according to an embodiment;

FIG. 3 schematically shows a flow for determining a state of a battery by an apparatus for diagnosing a battery according to an embodiment;

FIG. 4A shows a voltage graph of a battery voltage over time according to an embodiment

FIG. 4B shows a linear transformation graph before error correction used in an apparatus for diagnosing a battery according to an embodiment;

FIG. 5 shows feature values before error correction used in an apparatus for diagnosing a battery according to an embodiment;

FIG. 6 shows other feature values before error correction used in an apparatus for diagnosing a battery according to an embodiment;

FIG. 7 shows a structure of a battery module, which is a diagnosis target of an apparatus for diagnosing a battery according to an embodiment;

FIG. 8 shows a linear transformation graph after error correction used in an apparatus for diagnosing a battery according to an embodiment;

FIG. 9 shows feature values included in a discharge graph utilized in an apparatus for diagnosing a battery according to an embodiment;

FIG. 10 shows feature values included in a linear transformation graph utilized an apparatus for diagnosing a battery according to an embodiment;

FIG. 11 shows feature values included in an average graph utilized in an apparatus for diagnosing a battery according to an embodiment;

FIG. 12 shows feature values derived by an apparatus for diagnosing a battery according to an embodiment;

FIG. 13 shows feature values derived by an apparatus for diagnosing a battery according to an embodiment;

FIG. 14 shows a trend line generated by an apparatus for diagnosing a battery according to an embodiment;

FIG. 15 shows a control flowchart of a method of diagnosing a battery according to an embodiment; and

FIG. 16 shows a control flowchart of a method of diagnosing a battery according to an embodiment, following FIG. 15.

## MODE FOR CARRYING OUT THE INVENTION

Hereinafter, various embodiments disclosed in this document will be described in detail with reference to the accompanying drawings. In this document, the same reference numerals are used for the same components in the drawings, and duplicate descriptions of the same components are omitted.

For various embodiments disclosed in this document, specific structural or functional descriptions are provided only for the purpose of describing the embodiments, and the various embodiments disclosed in this document may be implemented in various forms and should not be construed as being limited to the embodiments described in this document.

Expressions such as "first," "second," "firstly," or "secondly" used in various embodiments may modify various components regardless of order and/or importance, and do not limit the components. For example, without departing from the scope of the embodiments disclosed in this document, a first component may be named as a second component, and similarly, a second component may be renamed as a first component.

The terms used in this document are used only to describe specific embodiments and may not be intended to limit the scope of other embodiments. The singular expression may include the plural expression unless the context clearly indicates otherwise.

All terms used herein, including technical or scientific terms, may have the same meaning as commonly understood by a person of ordinary skill in the art of the embodiments disclosed in this document. Terms defined in commonly used dictionaries may be interpreted as having the same or similar meaning in the context of related technology, and shall not be interpreted in an ideal or overly formal sense unless clearly defined in this document. In some cases, even terms defined in this document cannot be interpreted to exclude embodiments disclosed in this document.

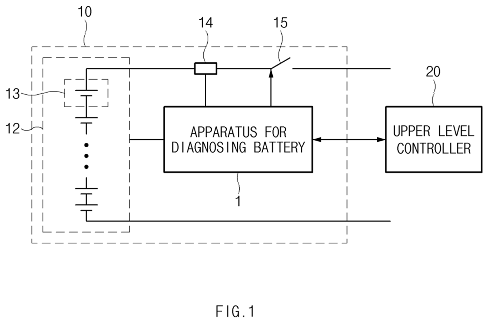

FIG. 1 is a block diagram showing a configuration of a general battery system including an apparatus for diagnosing a battery according to various embodiments.

Specifically, FIG. 1 schematically shows a battery system 10 according to an embodiment disclosed in this document and an upper level controller 20 included in an upper level system.

As shown in FIG. 1, the battery system 10 may include a plurality of battery modules 12, a sensor unit 14, a switching unit 16, and the apparatus 1 for diagnosing the battery. In this case, the battery system 10 may be provided with the plurality of battery modules 12, a plurality of sensor units 14, a plurality of switching units 16, and a plurality of apparatuses 1 for diagnosing a battery.

Each of the plurality of battery modules 12 may include at least one battery cell 13 capable of being charged and discharged. The battery cell 13 may include a positive electrode, a positive electrode material, a negative electrode, a negative electrode material, a separator, an electrolyte, polymers, and a case. In this case, the plurality of battery modules 12 may be connected in series or in parallel.

In addition, the battery system 10 may include a battery pack, and the battery pack may be configured by combining multiple battery modules 12, and a battery management system (BMS) may be included therein to monitor and control a battery state. In addition, the battery system 10 may include a battery bank, and the battery bank may configure an energy storage system by combining multiple battery packs.

The sensor unit 14 may include a current sensor, a voltage sensor, and a temperature sensor.

The current sensor may detect a current utilized during a process of determining the SOC of the battery cell 13.

The current sensor may measure a battery current flowing in the battery, i.e., a charging current and a discharging current, and transmit the measurement result to the apparatus 1 for diagnosing the battery. According to an embodiment, the current sensor may measure the battery current at a predetermined cycle during a charging cycle in which the battery is charged with power from an external apparatus 3 or a discharging cycle in which the battery is discharged, and transmit the measurement result to the apparatus 1 for diagnosing the battery.

The voltage sensor may be configured to be connected in parallel to the battery, detect a battery voltage, which is the voltage across both ends of the battery, and generate a voltage signal representing the detected battery voltage.

The temperature sensor may be configured to measure a battery temperature and generate a temperature signal representing the measured battery temperature. The temperature sensor may be disposed in the case so as to measure a temperature close to an actual temperature of the battery. For example, the temperature sensor may be attached to a surface of at least one battery cell included in a cell group, and may detect a surface temperature of the battery cell as the battery temperature.

The switching unit 16 may be connected in series to a positive (+) terminal side or a negative (-) terminal side of the battery module 12 to control a charging/discharging current flow of the battery module 12. For example, as the switching unit 16, at least one relay, magnetic contactor, etc. may be used depending on the specifications of the battery system 10.

The apparatus 1 for diagnosing the battery may monitor the voltage, current, temperature, etc. of the battery system 10 and control and manage the monitored voltage, current, temperature to prevent overcharging and over-discharging, etc., and may include, for example, a battery management system (BMS).

The apparatus 1 for diagnosing the battery serves as an interface for receiving various parameters, and may include a plurality of terminals and a circuit that is connected to these terminals and processes the received values. In addition, the apparatus 1 for diagnosing the battery may control ON/OFF of the switching unit 16, for example, a relay or a contactor, and may be connected to the battery module 12 to monitor a state of each battery module 12.

In addition, the apparatus 1 for diagnosing the battery may receive current data, voltage data, and temperature data from the sensor unit 14 to acquire battery data and diagnose a state of the battery.

The upper level controller 20 may transmit a control signal for controlling the battery module 12 to the apparatus 1 for diagnosing the battery. Accordingly, an operation of the apparatus 1 for diagnosing the battery may be controlled based on the control signal applied from the upper level controller 20. In addition, the battery module 12 may be a component included in an energy storage system (ESS). In this case, the upper level controller 20 may be a controller (BBMS) of a battery bank including a plurality of battery systems 10 or an ESS controller that controls the entire ESS including a plurality of battery banks. However, the battery system 10 is not limited to these uses.

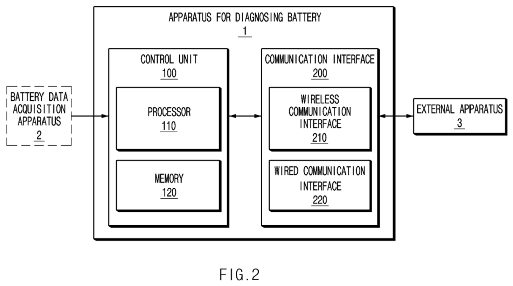

FIG. 2 is a block diagram showing a configuration of an apparatus for diagnosing a battery according to an embodiment.

Referring to FIG. 2, the apparatus 1 for diagnosing the battery according to an embodiment may include a control unit 100 including at least one processor 110 and a memory 120 and a communication interface 200, and diagnose a battery by communicating with the external apparatus 3 through the communication interface 200 and transmit the diagnosis result to the outside.

According to an embodiment, the apparatus 1 for diagnosing the battery may include a user terminal and/or a server apparatus capable of communicating with the external apparatus 3.

Specifically, when the apparatus 1 for diagnosing the battery is a user terminal, the control unit 100 of the apparatus 1 for diagnosing the battery may be configured as a CPU of the user terminal so as to diagnose the battery on-device from the user terminal. In this case, the user terminal may include, but is not limited to, a personal computer, a terminal, a portable telephone, a smart phone, a handheld device, a wearable device, etc.

In addition, when the apparatus 1 for diagnosing the battery is a server apparatus, the server apparatus may be implemented as various computing devices such as a workstation, a cloud, a data drive, a data station, etc. The server apparatus may be implemented as one or more server apparatuses physically or logically separated based on functions, detailed configurations of functions, or data, etc., and may transmit and receive data through communication between the server apparatuses and process the transmitted and received data.

The apparatus 1 for diagnosing the battery according to an embodiment may mean any electronic device including the processor 110 and the memory 120, and may be mounted in a vehicle and operated. Hereinafter, components of the apparatus 1 for diagnosing the battery will be described in detail.

A battery data acquisition apparatus 2 shown in FIG. 2 may include a data acquisition apparatus (DAQ) as a separate physical configuration. Here, the data acquisition apparatus may mean an apparatus that monitors a state and performance of the battery in real time using sensors and measuring equipment, stores data, and acquires analysis data.

In addition, the battery data acquisition apparatus 2 may be a configuration that operates inside the apparatus for diagnosing the battery. That is, the battery data acquisition apparatus 2 may operate as a hardware configuration inside the apparatus for diagnosing the battery or may operate in the form of software to acquire battery data.

Here, the battery data acquisition apparatus 2 may include a constant current power supply for applying a constant current signal and a data acquisition device (DAQ).

The communication interface 200 may include a wireless communication interface 210 and a wired communication interface 220 to communicate with the external apparatus 3. The communication interface 200 may transmit and receive programs for calculating characteristic values of battery cells, classifying classes, and estimating lifespan, or various data, from a separately provided external server.

The wireless communication interface 210 may include at least one of a short-range communication module and a long-range communication module.

The short-range communication module may communicate with the external apparatus 3 adjacent to the apparatus 1 for diagnosing the battery using a short-range communication method. Here, the short-range communication module may utilize one of communication methods of Bluetooth, Bluetooth low energy (BLE), infrared data association (IrDA), Zigbee, Wi-Fi, Wi-Fi direct, Ultra Wideband (UWB), or near field communication (NFC).

The long-range communication module may include a communication module that performs various types of long-range communication, and may include a mobile communication interface. The mobile communication interface may transmit and receive a wireless signal to and from at least one of a base station, an external terminal, and the external apparatus 3 on a mobile communication network. In addition, the long-range communication module may communicate with the external apparatus 3 or an external apparatus 3 such as another electronic device, through a nearby access point (AP). The access point (AP) may connect a local area network (LAN) to which the apparatus 1 for diagnosing the battery is connected to a wide area network (WAN) to which a communication server is connected. Accordingly, the apparatus 1 for diagnosing the battery may be connected to the communication server through the external apparatus 3 and the wide area network (WAN) to communicate with each other.

The wired communication interface 220 may connect to a wired communication network and communicate with the external apparatus 3 through the wired communication network. For example, the wired communication interface 220 may connect to a wired communication network through Ethernet (IEEE 802.3 technology standard) or connect to a wired communication network through CAN communication, and transmit and receive data to and from the external devices 3 through the wired communication network.

The apparatus 1 for diagnosing the battery according to an embodiment may include an input/output interface (not shown). An interface that allows data to be transmitted and received by connecting an input device (not shown) such as a keyboard, mouse, and touch panel and an output device (not shown) such as a display and the processor 110 to one another.

The memory 120 may store various information required for operating the apparatus 1 for diagnosing the battery. Specifically, the memory 120 may store an operating system and a program required for operating the apparatus 1 for diagnosing the battery, or may store data required for operating the apparatus 1 for diagnosing the battery. In addition, the memory 120 may also store a learning model related to machine learning required for operating the apparatus 1 for diagnosing the battery.

Specifically, the memory 120, may store various programs related to calculating feature values of battery cells, classifying classes, and estimating lifespan. In addition, the memory 120 may store various data such as voltage, current, temperature, and feature value data of each battery cell.

In addition, the memory 120 may store diagnosis results of a battery cell diagnosed by the processor 110 and specific information of the battery cell.

The memory 120 may include a volatile memory 120 such as a static random access memory (S-RAM) and a dynamic random access memory (D-RAM) for temporarily storing data. In addition, the memory 120 may include a nonvolatile memory 120 such as a read only memory (ROM), an erasable programmable read only memory (EPROM), and an electrically erasable programmable read only memory (EEPROM) for storing data for a long period of time.

The processor 110 outputs a control signal to control the apparatus 1 for diagnosing the battery as a whole. The processor 110 may include a single or a plurality of central processing units (CPUs) and graphics processing units (GPUs). In this case, the processor 110 may be implemented as an array of a plurality of logic gates, or may be implemented as a combination of a general-purpose microprocessor 110 and the memory 120 storing a program capable of being executed on the microprocessor 110.

Specifically, the processor 110 may perform error correction to correct the influence of a sensing line on battery data to generate preprocessed data, and here, the error correction to correct the influence of the sensing line may mean a process of correcting an error that occurs based on a physical structure of the battery module.

Specifically, the sensing line is a wiring that is disposed according to a structure of the battery cell, battery module, and battery pack when designing the battery module, and may be provided between the battery cell and the battery management device to perform the role of transmitting battery data. Accordingly, the sensing line may be provided in the battery module by considering the length, path, and protection device of the wiring so that the best performance may be achieved according to the purpose and use of the battery system.

The processor 110 may generate sensing line group data to remove the influence of the sensing line during a diagnosis process, and may perform error correction that removes the influence of the sensing line by correcting a difference between the sensing line group data.

In this case, the processor 110 may derive a correction value based on an average value of correction target data included in a plurality of sensing line group data and an average value of the remaining data at a point where a difference value between the sensing line group data is the maximum.

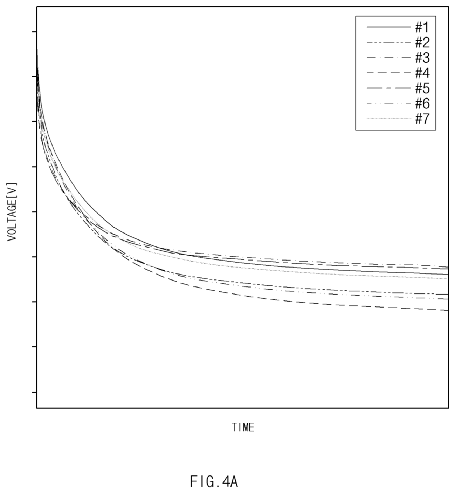

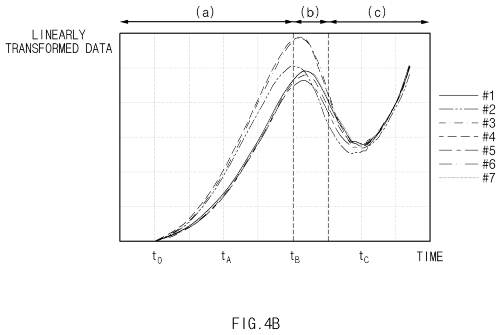

Specific details regarding error correction to correcting the influence of the sensing line will be described below with reference FIG. 4 and subsequent drawings.

In addition, the processor 110 may diagnose whether the battery pack is abnormal by applying a weight determined based on the structure of the battery module to the feature value. Here, the weight may mean a value for correcting an error that occurs depending on the structure and location of the battery pack.

The processor 110 may calculate a proximity degree from a reference battery cell for a plurality of battery cells included in the battery module, and may apply a weight differently based on the degree of proximity.

According to this, the processor 110 may correct errors that occur due to a difference in the location of the battery cell or a difference in the sensing structure, in addition to a difference caused by degradation or chemical properties of the battery.

In addition, the processor 110 may generate a trend line obtained by removing an outlier based on the correlation between a voltage value and the feature value included in the battery data, and may diagnose whether the battery pack is abnormal based on a distance from the trend line.

Hereinafter, an embodiment of diagnosing whether a battery module is abnormal by analyzing the correlation between the voltage value and the feature value will be described, but various other embodiments may be further included. For example, the processor 110 may analyze the correlation between the degree of battery degradation and the feature value, or the correlation between the internal resistance and the feature value.

As described above, the apparatus 1 for diagnosing the battery according to an embodiment may correct errors caused by a shape of the sensing line included in the battery module, and may improve the accuracy of diagnosis by considering the structure of the battery module.

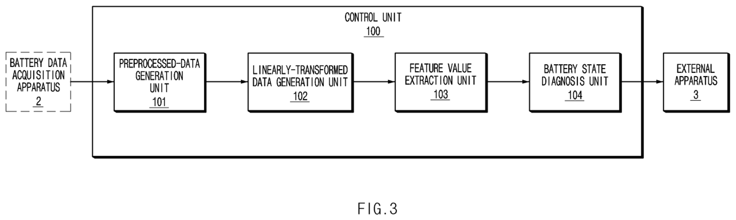

FIG. 3 schematically shows a flow for determining a state of a battery by an apparatus for diagnosing a battery according to an embodiment. In FIG. 3, configurations 101 to 104 are implemented in the form of software blocks and may be stored in the memory 120 and executed by the processor 110.

Referring to FIG. 3, at least one processor 110 may receive battery data acquired by applying a current signal to the battery module from the battery data acquisition apparatus 2 provided externally or included within the apparatus 1 for diagnosing the battery.

Here, the current signal applied to the battery module may include a discharging current signal after charging, and the current signal may include a constant current signal (CC-signal). Specifically, the current signal applied to the battery module may be applied as a single constant current signal or as a repeated constant current signal in a situation where charging and discharging are repeated, may be applied as a single constant current signal or as a repeated constant current signal in a situation where charging and resting are repeated, and may be applied as a single constant current signal or as a repeated constant current signal in a situation where discharging and resting are repeated.

That is, the current signal applied to the battery module may be a constant current signal suitable for dividing the components for ease of analysis based on the fact that a voltage change pattern is different for each chemical reaction. In this case, an acquisition cycle of battery data may be measured with a resolution of 1 mV or less and a measurement cycle of 10 ms or less, and may include various modified examples.

Thereafter, a preprocessed-data generation unit 101 of the control unit 100 may generate preprocessed data by removing noise and the influence of the sensing line from the battery data.

Specifically, the processor 110 may generate preprocessed data by classifying the charging, discharging, and resting sections in accordance with the synchronization between repeated or multiple applied signals. According to this, the degradation of accuracy due to the influence of the voltage resolution of the battery data acquisition apparatus 2 may be alleviated, and noise may be removed.

In addition, the processor 110 may generate preprocessed data by removing a preset initial time from data from one time charging or discharging data. According to this, noise that occurs due to the fast response characteristics of the battery cell in a current change section and occurs during the battery cell sensing process may be removed.

In addition, the processor 110 may generate preprocessed data by filtering noise at a certain time and frequency based on various filtering techniques. According to this, the fundamental noise and harmonic noise of mainly 50 Hz and 60 Hz may be removed.

In addition, the processor 110 may generate preprocessed data by dividing the battery data into structurally identical groups for patterns caused by the shape of the sensing line, defining a difference in voltage behavior between the groups, and correcting the difference between the groups by digitizing the difference.

Thereafter, a linearly-transformed data generation unit 102 of the control unit 100 may generate linearly transformed data obtained by performing linear transformation on cell voltage data. Here, the linear transformation may include computations performed on the cell voltage, such as calculating the amount of change in the cell voltage or calculating a differential value for the cell voltage. Hereinafter, a value included in the linearly transformed data may be referred to as a linearly transformed value.

The linearly transformed data may include linearly transformed values calculated based on the cell voltage. For example, the linearly transformed values may include an amount of change in the cell voltage, and a differential value obtained by differentiating the cell voltage based on the amount of change related to time. Specifically, the processor 110 may generate linearly transformed data based on Equation 1 or 2 below for the cell voltage data included in the battery data.

$$[\text{Equation 1}]$$

$$(V_{nt} - V_t)/\text{time change amount}$$

$$[\text{Equation 2}]$$

$$(V_{t2} - V_{t1})/\text{time change amount}$$

Here, the time change amount may be a time section corresponding to the difference between two points in time (e.g., n-th point in time nt to first point in time t) and may include a time-related section corresponding to the difference between two values related to time (e.g., log(nt) to log(t)).

The processor 110 may generate linearly transformed data based on a V value change rate of a first time section (t to nt) (a slope value obtained by first-order linear fitting of a V value of the first time section) and a V value change rate of a second time section (t1 to t2) (a slope value obtained by first-order linear fitting of a V value of the second time section). The reason for generating the linearly transformed data may be to clearly check a change in voltage values included in the battery data (e.g. voltage over time), and is to more easily determine the tendency of data of the battery cells by generating linearly transformed data. The equations and algorithm for generating linearly transformed data here are exemplary, and modified embodiments for generating linearly transformed data may be included. In addition, the processor 110 may perform normalization on the differential value derived based on Equation 1 or 2 above, and may derive a feature value from the normalized differential value.

A feature value extraction unit 103 of the control unit 100 may extract and correct a feature value by selecting a specific point in time from a graph obtained by linear transformation, or extract and correct individual components based on an equation regarding a chemical reaction.

In this case, the processor 110 may extract the feature value of a time zone in which the influence of the sensing line is the smallest, and the time zone in which the influence of the sensing line is the smallest may be acquired during the process of the processor 110 performing error correction, or may include a preset time zone.

Examples of the feature values extracted by the processor 110 may include a maximum linearly transformed value obtained from a linear transformation value graph, a point in time at the maximum linearly transformed value, a linearly transformed value at a specific point in time, etc., and various modified examples may be included.

Thereafter, a battery state diagnosis unit 104 of the processor 110 may diagnose a state of the battery cell based on the correlation between the extracted feature value and the voltage value.

Specifically, the processor 110 may remove an outlier that exhibits a peculiar behavior with respect to a graph of the feature value and the voltage value, and the outlier may mean a data point that falls outside a normal range of other data points based on visual or statistical methods.

The processor 110 may generate a trend line for a group from which the outlier has been removed, calculate a distance value from the trend line for each battery cell, and diagnose a battery cell whose distance value from the trend line is greater than or equal to a reference value as an abnormal battery cell.

Thereafter, the processor 110 may transmit information about the battery cell diagnosed as abnormal or normal to the external apparatus 3 through the communication interface 200, and accordingly, a user related to the battery may remotely check a diagnosis result of the battery cell.

FIG. 4A illustrates a voltage graph of a battery voltage over time according to an embodiment. FIG. 4B illustrates a linear transformation graph before error correction utilized in an apparatus for diagnosing a battery according to an embodiment.

Referring to FIG. 4A, the voltage graph may include voltage values of battery cells over time during a discharging process. The voltage graph of FIG. 4A may be included in battery data. Referring to FIGS. 4A and 4B, the processor 110 may perform preprocessing on battery data (e.g., the voltage graph of FIG. 4A) to acquire a linear transformation graph such as FIG. 4B.

Referring to the linear transformation graph of FIG. 4B, in area (a), it is difficult to determine a tendency of data of the battery cells, but in area (b), it may be seen that the data is divided into a first group (#1, #3, #5, and #7) and a second group (#2, #4, and #6).

The linear transformation graph may include a differential value for the voltage of the battery. Here, the differential value may be a differential value of the voltage based on the time change amount. The processor 110 may acquire preprocessed data by preprocessing the battery data and acquire a linearly transformed value obtained by performing a linear transformation including noise removal and differentiation based on the preprocessed data, and if the linearly transformed value for the preprocessed data is generated as a graph, it may be represented as in FIG. 4B.

In this case, the horizontal axis of FIG. 4B may mean time, and the vertical axis may mean the differential value of the voltage. In addition, each line may mean a different battery cell, and the indices on the right side of the graph may mean the numbers of the battery cells.

Referring to area (a), even though the processor 110 derived a differential value from a battery pack under the same conditions, it can be seen that the differential data is divided into two groups between $t_O$ and $t_B$. Here, $t_O$ and $t_B$ may correspond to the voltage measurement point in time (the unit is sec or msec, etc.).

Such a separation phenomenon may occur due to the influence of the sensing line that senses the battery data, and may occur due to, for example, a mutual coupling phenomenon in which two or more electrical elements interact with each other's electromagnetic fields and affect each other in an opposite direction to the expected effect.

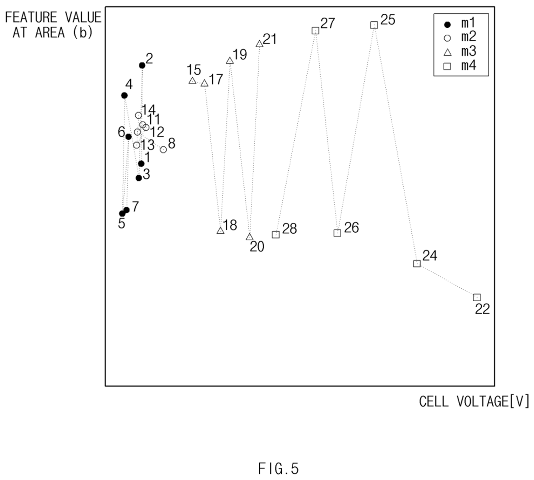

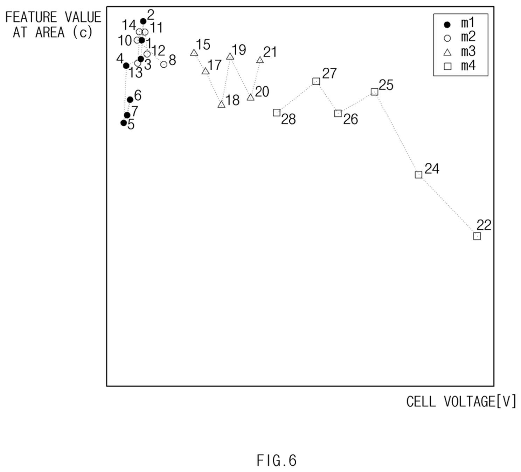

Specifically, the influence of the separation phenomenon on the battery diagnosis will be described together with area (b) of FIG. 4B and FIG. 5, and area (c) of FIG. 4B and FIG. 6.

FIG. 5 shows feature values before error correction utilized in an apparatus for diagnosing a battery according to an embodiment, and FIG. 6 shows other feature values before error correction utilized in an apparatus for diagnosing a battery according to an embodiment.

First, referring to area (b) of FIG. 4B and FIG. 5 together, in area (b) of FIG. 4B, due to the influence of the sensing line, the differential graph for each battery cell may be displayed as divided into No. 4, No. 6, and the rest (No. 1, No. 2, No. 3, No. 5, and No. 7). In this way, if feature values are extracted from area (b) of FIG. 4B, feature values may be derived in the form of a zigzag in the up and down directions, as shown in FIG. 5.

Continuing to refer to FIG. 5, indices of m1 to m4 may mean the numbers of battery modules. In addition, the horizontal axis may mean the cell voltage in a resting state before signal application, and the vertical axis may mean the feature value extracted from area (b) of FIG. 4B.

When the influence of the sensing line is not corrected, there may be a possibility that accurate diagnosis may be hindered due to locations of the feature values of the cells included in a specific module to be diagnosed. For example, when there are abnormal cells that have feature values that are similar to those of cells No. 28, No. 26, No. 24, and No. 22 corresponding to module No. 4 illustrated in FIG. 5, accurate diagnosis may be hindered.

Similarly, referring to area (c) of FIG. 4B and FIG. 5 together, the influence of the sensing line is reduced in area (c) of FIG. 4B compared to area (b), so that the distinction of the linear transformation graph for each battery cell may be reduced and displayed. In this way, when feature values are extracted from the area (c) of FIG. 4B, the feature values may be derived in a zigzag shape in the up and down directions, as shown in FIG. 6, in a form in which the difference between the feature values is reduced compared to FIG. 5.

Continuing to refer to FIG. 6, the indices m1 to m4 may mean the numbers of battery modules, similar to FIG. 5. In addition, the horizontal axis may mean the cell voltage in a resting state before signal application, and the vertical axis may mean the feature values extracted from area (c) of FIG. 4B.

When the influence of the sensing line is reduced, the feature values of the cells may be distinguished, and thus the accuracy of the diagnosis may be improved.

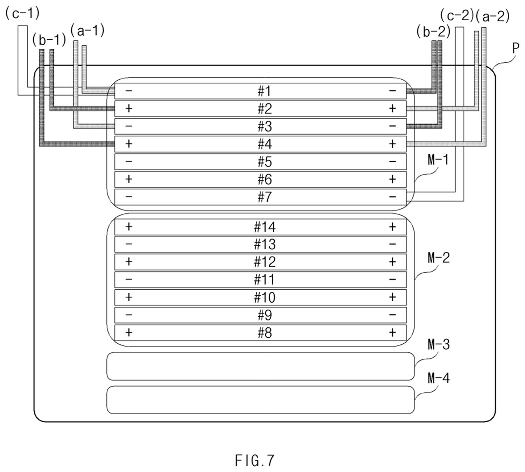

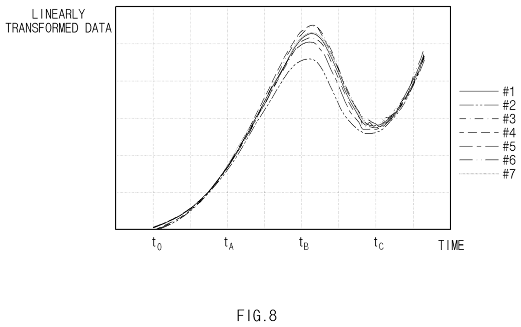

Based on this fact, the apparatus 1 for diagnosing the battery according to an embodiment may correct the influence of the sensing line, and the specific correction principle and result will be described with reference to FIGS. 7 and 8.

FIG. 7 shows a structure of a battery pack, which is a diagnosis target of an apparatus for diagnosing a battery according to an embodiment, and FIG. 8 shows a linear transformation graph after error correction utilized in an apparatus for diagnosing a battery according to an embodiment.

Referring to FIG. 7, an example of the structure of a battery pack P, battery modules M-1, M-2, M-3, and M-4, and battery cells #1 to #14 for which a diagnosis is performed in the apparatus 1 for diagnosing the battery according to an embodiment is shown.

Specifically, the battery cells #1 to #14 may constitute the battery modules M-1 and M-2, and the multiple battery modules M-1, M-2, M-3, and M-4 may constitute the battery pack P. Each of sensing lines a-1, a-2, b-1, and b-2 monitors the state of each cell, and powers line c-1 and c-2 may transmit power to the battery pack P.

In the case of the battery cells #1 to #7 included in the battery module M-1, sensing may be performed by different sensing lines for odd-numbered battery cells #1, #3, #5, and #7 and even-numbered battery cells #2, #4, #6, and #8.

In addition, since the battery cells #1 to #7 included in the battery module M-1 are influenced by different power lines c-1 and c-2 due to differences in physical location and structure thereof, a difference may occur in the battery data acquired even under the same conditions.

In addition, each of the battery module M-1, M-2, M-3, and M-4 may have a different heat distribution depending on the location thereof, and the pressure applied thereto may vary depending on a stacking method and structure. Accordingly, the voltage, internal resistance, and capacity of each of the battery modules M-1, M-2, M-3, and M-4 may vary, and the processor 110 may apply a weight to each battery data to correct the difference according to the location of the battery module.

Specifically, the processor 110 may equally apply weights to feature values corresponding to the same battery module or corresponding to the same sensing structure, and the processor 110 may differently apply weights to feature values based on the relative locations between the plurality of battery modules or the relative locations of power lines connected to the plurality of battery modules and the battery pack.

That is, the processor 110 assigns the same weight to feature values extracted from the same battery module because the feature values show similar behaviors, and since the feature value extracted from a different battery module shows different behavior depending on the location or structure of each battery module, the processor 110 may correct the difference in behavior by assigning a different weight to the feature value.

In addition, the processor 110 may set weights when designing a battery system to correct electromagnetic influences on the plurality of sensing lines or power lines as in FIG. 7, and may utilize an algorithm or machine learning model to derive an optimal weight.

The apparatus 1 for diagnosing the battery according to an embodiment may eliminate the influence of the sensing line through equivalent analysis to correct the influence of the sensing line.

Specifically, in the case where a direction or path of a sensing loop between the even-numbered and odd-numbered battery cells is different as in the exemplary structure of FIG. 7, the mutual coupling pattern may occur in the opposite direction, and thus the battery cells show opposing tendencies for a certain period of time immediately after the current change.

In an embodiment, as one of the methods for correcting the influence of the sensing line, the processor 110 may perform, for odd-numbered battery cells, correction based on i) a linearly transformed value measured from an existing odd-numbered battery cell, ii) an average of linearly transformed values in odd-numbered battery cells (first average), iii) an average of linearly transformed values in even-numbered battery cells (second average), and iv) a value (e.g., an arithmetic mean of the first average and the second average) based on the average of linearly transformed values in the odd-numbered battery cells (first average) and the average of linearly transformed values in the even-numbered battery cells (second average) (e.g., an arithmetic mean of the first average and the second average).

Here, the reason for calculating the first average and the second average separately may be because the number of odd-numbered battery cells and the number of even-numbered battery cells may be different. When an average of the linearly transformed values in all battery cells is calculated without distinguishing between odd-numbered battery cells and even-numbered battery cells, the proportion related to the linearly transformed values in the odd-numbered battery cells may be reflected more significantly. For example, when the number of odd-numbered battery cells is four and the linearly transformed values are {1, 3, 8, 12} respectively, and the number of even-numbered battery cells is three and the linearly transformed values are {2, 4, 6} respectively, the first average may be calculated as 6 (a value corresponding to ii) described above), the second average may be calculated as 4 (a value corresponding to iii) described above), and an average value of the first average and the second average may be calculated as 5 (a value corresponding to iv) described above). On the other hand, if the average of the entire linearly transformed value is calculated without distinguishing between odd-numbered battery cells and even-numbered battery cells, a value of the average may be calculated as 5.14, which is closer to the first average. In summary, if the average value of the linear transformation values in the entire battery cells is calculated, since the linearly transformed values of the odd-numbered battery cells may be more reflected in the average value, and the influence of the sensing line can be more accurately corrected by distinguishing the first average and the second average and calculating the first average and the second average.

Specifically, the processor 110 may acquire a corrected linearly transformed value of the odd-numbered battery cell by deducting a value obtained by subtracting iv) from ii) as the v) correction value and excluding the v) correction value from i). The aforementioned linearly transformed value may include a value obtained by differentiating the voltage value V of each battery cell based on an amount of change in logarithmic time (e.g., log(t)).

Likewise, the processor 110 may perform, for the even-numbered battery cells, correction based on i) the linearly transformed value measured from the existing even-numbered battery cell, ii) the average of the linearly transformed values in the even-numbered battery cells (second average), and iii) a value based on an average of the linearly transformed values in the even-numbered battery cells (second average) and an average of the linearly transformed values in the odd-numbered battery cells (first average) (e.g., an arithmetic mean value of the first average and the second average) in order to correct the influence of the sensing line.

Specifically, the processor 110 may acquire the corrected linearly transformed value of the even-numbered battery cell by deducting the value obtained by subtracting iii) from ii) as a iv) correction value and excluding the iv) correction value from i).

However, the battery structure of FIG. 7 is exemplary, and various structural modifications may exist depending on the shape of the battery (e.g., square, cylindrical, pouch type, etc.) and the application product of the battery (e.g., electric vehicle, ESS, robot, etc.). Therefore, there may be various modified examples (e.g., a method using an electromagnetic model, a method using scale adjustment, etc.) in the method of correcting the influence of the sensing line, and the correction may be performed in a manner equivalent to the apparatus 1 for diagnosing the battery according to an embodiment through equivalent analysis.

In this way, the processor 110 may acquire a linear transformation graph as in FIG. 8 by removing the influence of the sensing line.

Referring to FIG. 8, the processor 110 may remove noise from battery data, perform error correction to acquire preprocessed data, and acquire linearly transformed values obtained by performing linear transformation on the preprocessed data. If the linearly transformed values for the preprocessed data for which the influence of the sensing line is corrected are generated as a graph, linearly transformed values may be represented as in FIG. 8.

In this case, the horizontal axis of FIG. 8 may mean time (e.g., the unit may be [ms]), and the vertical axis may mean the linearly transformed value. In addition, each line may mean a different battery cell, and the indices on the right side of the graph may mean the numbers of the battery cells.

That is, in FIG. 4B, since the influence of the sensing line is not corrected, the graph corresponding to the battery cells may be represented by being divided into two groups. When feature values are extracted from data divided into two groups, inaccurate battery diagnosis may be made.

Accordingly, the apparatus 1 for diagnosing the battery according to an embodiment may perform error correction to remove the influence of the sensing line in order to alleviate the inaccurate battery diagnosis. If the processor 110 performs error correction as shown in FIG. 8, the linearly transformed values for each battery cell forms a group, so that uniform feature values may be derived according to the height of the linearly transformed value.

Hereinafter, an example of deriving a feature value utilized in the apparatus 1 for diagnosing the battery according to an embodiment will be described.

Specifically, the processor 110 may select a meaningful point in time in the linear transformation graph, extract a value at that point in time, and utilize the value as a feature value. In addition, through linear transformation, the chemical reaction of the battery may be analyzed based on an equation, and extracted as individual components.

In this process, the processor 110 may select the feature value of a time zone with the least influence of the sensing line, and the process of selecting the feature value of the time zone with the least influence of the sensing line may be performed in parallel with a task of correcting the influence of the sensing line.

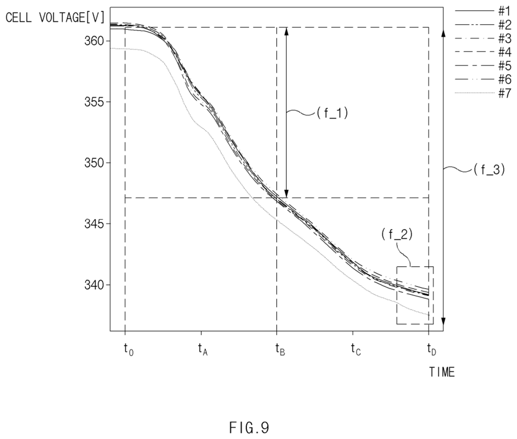

FIG. 9 shows feature values included in a discharge graph according to an embodiment. In this case, the horizontal axis of FIG. 9 may mean time (e.g., the unit may be [ms]), and the vertical axis may mean the cell voltage.

In addition, the indices on the right may mean different battery cells #1 to #7, and each line may mean a discharge graph of each of the battery cells #1 to #7.

Specifically, the processor 110 may extract a plurality of different feature values by cropping a specific section of the discharge graph. That is, the processor 110 may determine a resistance value at a specific point in time (e.g., a point in time of 10 ms) as feature 1 (f_1) based on Equation 3 below. Here, V is the voltage at each point in time, and I is the current.

[Equation 3]

$$f\_1 = (V_{(t=10\text{ms})} - V_{(t=0ms)})/I$$

In addition, the processor 110 may determine the slope after the first-order linear fitting of a specific section (e.g. 900 to 1000 ms section) as feature 2 (f_2).

To this end, the processor 110 may perform the first-order linear fitting based on techniques such as the least squares method, maximum likelihood estimation, and least absolute deviations, and the processor 110 may find a straight line in the form of y = mx + b for the time t and voltage V.

Here, y may mean the voltage V, which is a dependent variable, x may mean the time t, which is an independent variable, m may mean the slope corresponding to feature 2 (f_2), and b may mean the y-intercept.

In addition, the processor 110 may determine a resistance value at a specific point in time (e.g., 1000 ms point in time) as feature 3 (f_3) based on Equation 4 below. Here, V is the voltage at each point in time, and I is the current.

[Equation 4]

$$f\_3 = [\![(V]\!]\_(t = 1000\text{ms}) - V\_(t = 0ms))/I$$

In particular, the processor 110 may generate diagnostic indicators through correlation analysis with other feature values for feature 1(f_1), feature 2(f_2), and feature 3(f_3), similar to feature 0(f_0), and may diagnose the battery by utilizing the generated diagnostic indicators.

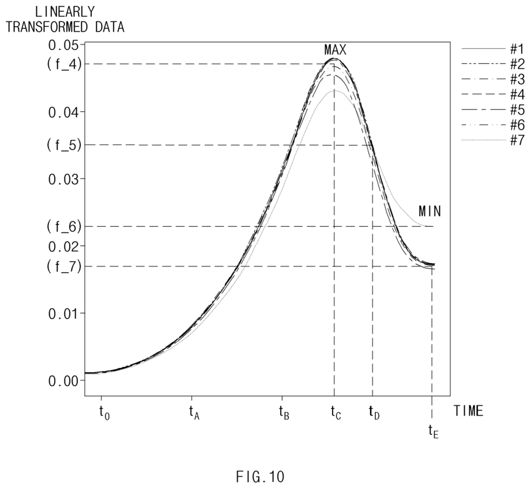

FIG. 10 shows feature values included in the linear transformation graph utilized in an apparatus for diagnosing a battery according to an embodiment. In this case, the horizontal axis of FIG. 10 may mean the time, and the vertical axis may mean the linearly transformed value.

In addition, the indices on the right may mean different battery cells #1 to #7, and each line may mean a linear transformation graph of each of the battery cells #1 to #7.

The processor 110 may extract a plurality of different feature values from a graph obtained after removing an initial section (e.g., the initial 3 ms) of the linear transformation graph and applying a filter with a cutoff frequency of 60 Hz using a low-pass filter (LPF).

Specifically, the processor 110 may determine the linearly transformed value having the maximum value as feature 4 (f_4), determine the linearly transformed value at any point in time (e.g., 100 ms) as feature 5 (f_5), and may determine a final point of the battery cell #7 whose height of the highest point has the minimum value as feature 6 (f_6).

In addition, the processor 110 may determine the linearly transformed value at any point in time (e.g., $t_E$ is 490 ms) as feature 7 (f_7), and may determine a point in time at which the linearly transformed value has the maximum value as feature 8 (f_8).

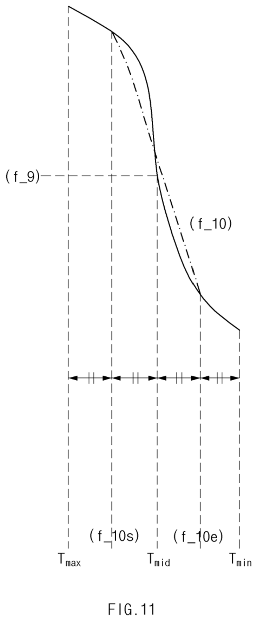

FIG. 11 illustrates feature values included in an average graph that is utilized in an apparatus for diagnosing the battery according to an embodiment. In this case, the horizontal axis of FIG. 11 may mean time, and the vertical axis may mean the linearly transformed value.

The processor 110 may acquire logarithmic differential values from all battery cells included in the battery pack, and extract a plurality of feature values by partially cropping a graph obtained by averaging the linearly transformed values for the entire battery pack.

The processor 110 may derive the maximum value and minimum value of the linearly transformed values from the graph obtained by averaging the linearly transformed values for the entire battery pack, and may determine the times at the corresponding maximum value and minimum value as $T_{max}$ and $T_{min}$, respectively.

Thereafter, the processor 110 may use Equations 5 to 7 below to derive feature 9 (f_9) and feature 10 (f_10).

[Equation 5]

$$T\_mid = \sqrt{(T\_max \, [\![ * \, T\_min \, ]\!] )}$$

[Equation 6]

$$f\_10s = \sqrt{(T\_max \, [\![ * \, T\_mid \, ]\!] )}$$

[Equation 7]

$$f\_10e = \sqrt{(T\_min \, [\![ * \, T\_mid \, ]\!] )}$$

The processor 110 may determine a point in time of 1/4 division from the section of $T_{max}$ to $T_{min}$ as f_10s, and determine a point in time of 3/4 division from the section of $T_{max}$ to $T_{min}$ as f_10e. In this case, if f_10s is a value before 20 ms, f_10s may be fixed to 20 ms.

Thereafter, the processor 110 may determine the linearly transformed value of the point in time $T_{mid}$ as feature 9 (f_9), and may determine the slope after the first-order linear fitting from the section of f_10s to f_10e as f_10.

In this way, the apparatus 1 for diagnosing the battery according to an embodiment can select feature values from various battery data and linear transformation graphs, and diagnose the battery according to the correlation of the feature values, so that the battery can be quickly inspected by targeting various environments.

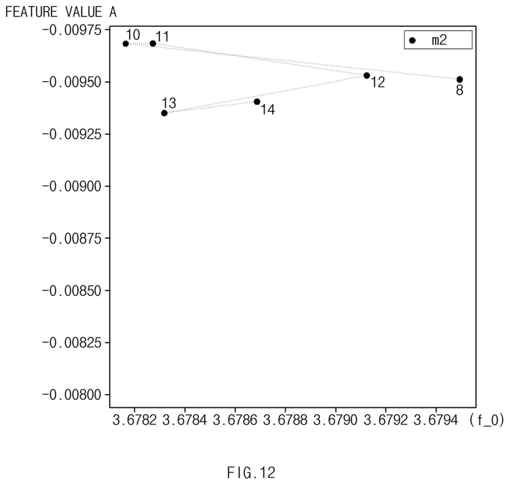

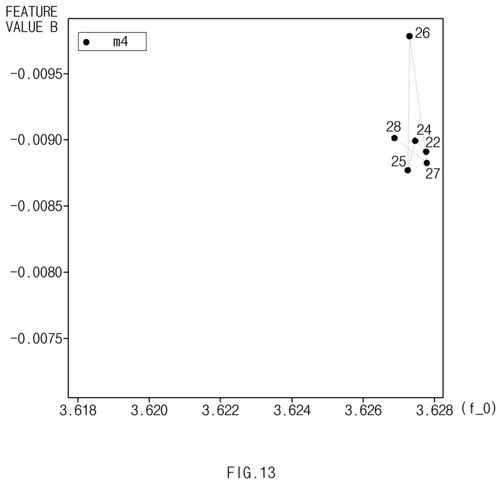

FIG. 12 shows feature values derived by an apparatus for diagnosing a battery according to an embodiment. FIG. 13 shows feature values different from those in FIG. 12 an apparatus for diagnosing a battery according to an embodiment.

First, referring to FIG. 13, the horizontal axis may mean feature 0 (f_0) value, which may represent the cell voltage in a resting state before signal application, and the vertical axis may mean any feature value A among the feature values selected by the processor 110.

In addition, m2 in the indices at the top right of the graph may mean any battery module number.

Since the graph illustrated in FIG. 12 is a result in which the influence of the sensing line is corrected, a feature value A of cells No. 8, No. 10, No. 11, No. 12, No. 13, and No. 14 that respectively correspond to the battery cells included in module No. 2 may be confirmed. Here, the feature value A of cells No. 8, No. 10, No. 11, No. 12, No. 13, and No. 14 is included in a normal category and may be diagnosed as a normal cell, and a cell differs from the feature value A of the cells by a specified value or more on the horizontal or vertical axis may be diagnosed as an abnormal cell.

In this way, according to the feature values derived by the apparatus 1 for diagnosing the battery according to an embodiment, the state of the battery cell (e.g., normal or abnormal) may be clearly distinguished in the vertical direction on the graph, and thus the state of the battery cell may be diagnosed.

Next, referring to FIG. 13, the horizontal axis may mean feature 0 (f_0) value, which may mean the cell voltage in a resting state before signal application, and the vertical axis may mean any feature value B among the feature values selected by the processor 110.

In addition, m4 in the indices at the top left of the graph may mean any battery module number.

Since the graph illustrated in FIG. 13 is also a result, in which the influence of the sensing line is corrected, similar to FIG. 13, a feature value B of cells No. 22, No. 24, No. 25, No. 26, No. 27, and No. 28 that respectively correspond to the battery cells included in module No. 4 may be confirmed. Here, the feature value B of cells No. 22, No. 24, No. 25, No. 26, No. 27, and No. 28 is included in a normal category and may be diagnosed as a normal cell, and a cell differs from the feature value B of the cells by a specified value or more on the horizontal or vertical axis may be diagnosed as an abnormal cell.

In this way, according to the feature values derived by the apparatus 1 for diagnosing the battery according to an embodiment, the state of the battery cell (e.g., normal or abnormal) may be clearly distinguished in the vertical direction on the graph, and thus the state of the battery cell may be diagnosed.

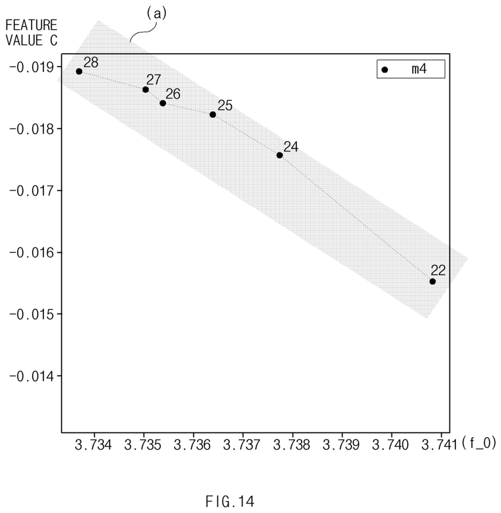

The apparatus 1 for diagnosing the battery according to an embodiment can diagnose whether the battery is abnormal even in the states of FIG. 12 and FIG. 13, and can improve the accuracy of the diagnosis by removing an outlier having peculiar behavior based on battery characteristics as in FIG. 14.

Subsequently, referring to FIG. 14, the horizontal axis may mean feature 0 (f_0) value, which may mean the cell voltage in the resting state before signal application, and the vertical axis may mean any feature value C among the feature values selected by the processor 110.

In addition, area (a) means a normal area that represents a preset distance from the trend line after an outlier is removed by the processor 110 in the trend line generation process.

Accordingly, the processor 110 may determine a battery cell included in the area (a) as a normal battery cell, and determine a battery cell detected outside the area (a) as an abnormal battery cell.

Here, as a method for removing the outlier by the processor 110, a statistical technique utilizing the mean, standard deviation, interquartile range, etc. or a machine learning technique utilizing the isolation forest, local outlier factor (LOF), One-Class support vector machine (One-Class SVM), etc. may be utilized.

In this way, the apparatus 1 for diagnosing the battery according to an embodiment may identify the trend of the normal range in a group in which outliers of peculiar behavior are removed from all battery cells, and thus there is an effect of improving the accuracy of analysis.

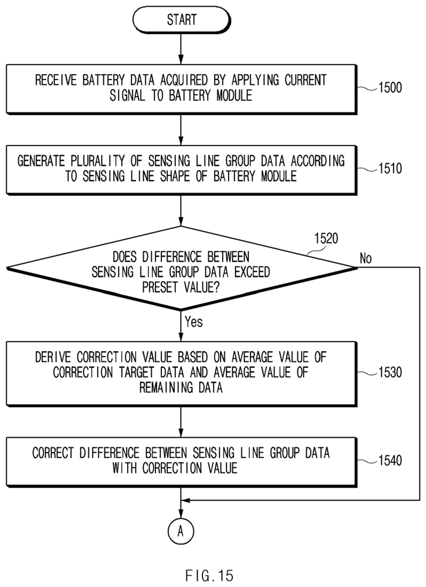

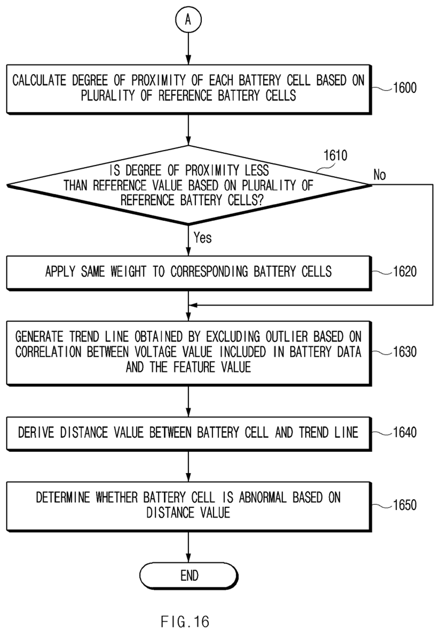

FIG. 15 shows a control flow diagram of a method for diagnosing a battery according to an embodiment, and FIG. 16 continues to show a control flow diagram of the method for diagnosing the battery according to the embodiment, following FIG. 15.

Referring to FIG. 15, the processor 110 may receive battery data acquired by applying a current signal to a battery module (1500). Here, the battery data acquired by applying the current signal may include battery data acquired by applying a current signal to the battery module by the processor 110, battery data acquired by the external apparatus 3, and battery data received by a server apparatus.

Thereafter, the processor 110 may generate a plurality of sensing line group data according to a sensing line shape of the battery module (1510), and the processor 110 may determine whether a difference between the sensing line group data exceeds a preset value (1520).

That is, when it is determined that the difference between the sensing line group data does not exceed the preset value (NO at 1520), the processor 110 may not perform error correction to remove the influence of the sensing line, as the influence of the sensing line is cancelled out and does not influence feature value extraction.

On the other hand, when it is determined that the difference between the sensing line group data exceeds the preset value (Yes at 1520), the processor 110 may derive a correction value based on an average value of the correction target data and an average value of the remaining data (1530).

Thereafter, the processor 110 may correct the difference between the sensing line group data with a correction value (1540). Here, the processor 110 may correct the sensing line influence by eliminating the difference between the sensing line group data through equivalent analysis.

Continuing to referring to FIG. 16, the processor 110 may calculate a degree of proximity of each battery cell based on a plurality of reference battery cells (1600). That is, the processor 110 may derive the degree of proximity based on the location of each battery cell.

Thereafter, the processor 110 may determine whether the degree of proximity is less than a reference value based on the plurality of reference battery cells (1610). That is, the processor may determine how close each battery cell is located based on a reference battery cell with which a relative location of each battery cell can be defined.

The processor 110 may apply the same weight to the battery cells (1620) if the degree of proximity is less than the reference value based on the plurality of reference battery cells (Yes at 1610). That is, the processor 110 may minimize environmental errors in battery diagnosis by applying the same weight to adjacent battery cells based on the fact that the adjacent battery cells are exposed to similar environments (e.g., temperature, pressure, etc.).

According to this, a uniform battery diagnosis environment may be created by correcting the deformation of battery data due to physical characteristics such as the location and structure of the battery module and the deformation of battery data due to the sensing structure.

Thereafter, the processor 110 may generate a trend line obtained by excluding the outlier based on the correlation between the voltage value included in the battery data and the feature value (1630), and the processor 110 may derive a distance value between the battery cell and the trend line (1640).

Here, the distance value between the battery cell and the trend line may mean the distance value between the location of the feature value measured from the battery cell and the trend line, and the processor 110 may utilize a distance measurement algorithm such as the Euclidean distance and the Dijkstra algorithm to derive the distance value.

Thereafter, the processor 110 may determine whether the battery cell is abnormal based on the distance value. In an embodiment, the processor 110 may determine whether the distance value between the feature value for the derived battery cell and the trend line is greater than or equal to a preset reference value

(1650). If it is determined that the distance value between the derived battery cell and the trend line is less than the preset reference value, the processor 110 may diagnose the battery cell as normal, and if it is determined that the distance value between the feature value for the derived battery cell and the trend line determined to exceed the preset reference value, the processor 110 may diagnose the battery cell as abnormal.

In this way, the apparatus 1 for diagnosing the battery according to an embodiment may remove the influence of the structure of the battery module when diagnosing an abnormality such as lithium plating in a battery cell, and may accurately and quickly diagnose the battery according to various characteristic values, and thus the time required for battery diagnosis is shortened and costs are reduced.

Meanwhile, the disclosed embodiments may be implemented in the form of a recording medium storing instructions executable by a computer. The instructions may be stored in the form of program code, which, when executed by a processor, may generate program modules to perform the operations of the disclosed embodiments. The recording medium may be implemented as a computer-readable recording medium.

The computer-readable recording media includes all types of recording media storing instructions that may be decoded by a computer. The computer-readable recording media may include, for example, a read only memory (ROM), a random access memory (RAM), a magnetic tape, a magnetic disk, a flash memory, an optical data storage device, etc.

In addition, the computer-readable recording medium may be provided in the form of a non-transitory storage medium. Here, the term 'non-transitory storage medium' simply means a tangible device that does not contain signals (e.g., electromagnetic waves), and this term does not distinguish between a case where data is stored semi-permanently in the storage medium and a case where data is stored temporarily. For example, a 'non-transitory storage medium' may include a buffer in which data is temporarily stored.

According to an embodiment, the method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store (e.g., Play Store™), distributed directly between two user devices (e.g., smartphones), or distributed online (e.g., downloaded or uploaded). In the case of online distribution, at least a part of the computer program product (e.g., a downloadable app) may be temporarily stored or temporarily generated in a machine-readable recording medium, such as a memory of a manufacturer's server, an application store's server, or an intermediary server.

In the above, even though all the components constituting the embodiments disclosed in this document have been described as being combined or operated in combination, the embodiments disclosed in this document are not necessarily limited to these embodiments. That is, within the scope of the purpose of the embodiments disclosed in this document, all of the components may be selectively combined and operated in combination with one or more of them.

The terms "include," "configure," or "have" described above, unless specifically stated to the contrary, mean that the corresponding component may be included therein, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and those skilled in the art to which the embodiments disclosed in this document belong may make various modifications and variations without departing from the essential characteristics of the embodiments disclosed in this document. Accordingly, the embodiments disclosed in this document are not intended to limit the technical ideas of the embodiments disclosed in this document, but rather to describe them, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of the rights of this document.

**Claims**

1. An apparatus for diagnosing a battery, comprising:

   a communication interface for receiving battery data acquired by applying a current signal to a battery module; and
   at least one processor for performing error correction to correct an influence of a sensing line related to a structure of the battery module and generating preprocessed data from the battery data, extracting a feature value based on the preprocessed data, and diagnosing a state of the battery module based on the feature value.

2. The apparatus of claim 1, wherein the at least one processor applies linear transformation to the preprocessed data to acquire linearly transformed data and extracts the feature value from the linearly transformed data.

3. The apparatus of claim 1, wherein the at least one processor groups the battery data according to a sensing line shape of the battery module to generate a plurality of sensing line group data, and generates the preprocessed data by correcting a difference between the sensing line group data with a correction value.

4. The apparatus of claim 3, wherein the at least one processor derives the correction value at a point where a difference value between the sensing line group data is maximum, and corrects a difference between the sensing line group data with the correction value.

5. The apparatus of claim 4, wherein the at least one processor derives the correction value based on an average value of correction target data included in the plurality of sensing line group data and an average value of the remaining data.

6. The apparatus of claim 5, wherein the at least one processor derives a value obtained by excluding an average value of the average value of the correction target data and the average value of the remaining data from the average value of the correction target data as the correction value, and corrects the difference with the correction value.

7. The apparatus of claim 1, wherein the at least one processor diagnoses the state of the battery module by applying a weight determined based on the structure of the battery module to the feature value.

8. The apparatus of claim 7, wherein the at least one processor calculates a degree of proximity of a plurality of battery cells included in the battery module, and diagnoses the state of the battery module by applying the weight differently to the feature value based on the degree of proximity.

9. The apparatus of claim 8, wherein the at least one processor diagnoses the state of the battery module by applying the weight differently to the feature value based on relative locations of power lines connected to the plurality of battery cells and the battery module.

10. The apparatus of claim 1, wherein the at least one processor generates a trend line obtained by removing an outlier based on a correlation between a voltage value included in the battery data and the feature value, and diagnoses the state of the battery module based on the trend line.

11. The apparatus of claim 10, wherein the at least one processor derives a distance value between a feature value for each battery cell included in the battery module and the trend line, and diagnoses a battery cell whose distance value is greater than or equal to a preset reference value as abnormal.

12. A method of diagnosing a battery, comprising:

receiving battery data acquired by applying a current signal to a battery module;
performing error correction to correct an influence of a sensing line related to a structure of the battery module and generating preprocessed data from the battery data;
extracting a feature value based on the preprocessed data; and
diagnosing a state of the battery module based on the feature value.

13. The method of claim 12, wherein the extracting of the feature value may include applying linear transformation to the preprocessed data to acquire linearly transformed data, and extracting the feature value from the linearly transformed data.

14. The method of claim 12, wherein the generating of the preprocessed data comprises grouping the battery data according to a sensing line shape of the battery module to generate a plurality of sensing line group data, and generating the preprocessed data by correcting a difference between the sensing line group data with a correction value.

15. The method of claim 14, wherein the correcting of the difference between the sensing line group data comprises deriving the correction value at a point where a difference value between the sensing line group data is maximum, and correcting a difference between the sensing line group data with the correction value.

16. The method of claim 15, wherein the deriving of the correction value comprises deriving the correction value based on an average value of correction target data included in the plurality of sensing line group data and an average value of the remaining data.

17. The method of claim 16, wherein the deriving of the correction value comprises deriving a value obtained by excluding an average value of the average value of the correction target data and the average value of the remaining data from the average value of the correction target data as the correction value.

18. The method of claim 12, wherein the diagnosing of the state of the battery module comprises diagnosing a state of the battery module by applying a weight determined based on the structure of the battery module to the feature value.

19. The method of claim 18, wherein the diagnosing of the state of the battery module comprises calculating a degree of proximity of a plurality of battery cells included in the battery module, and diagnosing the state of the battery module by applying the weight equally to the feature value based on the degree of proximity.

20. The method of claim 19, wherein the diagnosing of the state of the battery module comprises diagnosing the state of the battery module by applying the weight differently to the feature value based on relative locations of power lines connected to the plurality of battery modules and the battery module.

21. The method of claim 12, wherein the diagnosing of the state of the battery module comprises generating a trend line obtained by removing an outlier based on a correlation between a voltage value included in the battery data and the feature value, and diagnosing the state of the battery module based on the trend line.

22. The method of claim 21, wherein the diagnosing of the state of the battery module comprises deriving a distance value between a feature value for each battery cell included in the battery module and the trend line, and diagnosing a battery cell whose distance value is greater than or equal to a preset reference value as abnormal.

FIG.1

APPARATUS FOR DIAGNOSING BATTERY
1

CONTROL UNIT
100

PROCESSOR
110

MEMORY
120

COMMUNICATION INTERFACE
200

WIRELESS COMMUNICATION INTERFACE
210

WIRED COMMUNICATION INTERFACE
220

BATTERY DATA ACQUISITION APPARATUS
2

EXTERNAL APPARATUS
3

FIG.2

FIG.3

FIG.4A

FIG.4B

FIG.5

FIG.6

FIG.7

FIG.8

FIG.9

FIG.10

FIG.11

FIG.12

FIG.13

FIG.14

```
                    ┌─────────────┐
                    │    START    │
                    └──────┬──────┘
                           │
                           ▼
       ┌───────────────────────────────────────────┐
       │ RECEIVE BATTERY DATA ACQUIRED BY APPLYING  │
       │ CURRENT SIGNAL TO BATTERY MODULE           │─── 1500
       └───────────────────┬───────────────────────┘
                           │
                           ▼
       ┌───────────────────────────────────────────┐
       │ GENERATE PLURALITY OF SENSING LINE GROUP   │
       │ DATA ACCORDING TO SENSING LINE SHAPE OF    │─── 1510
       │ BATTERY MODULE                             │
       └───────────────────┬───────────────────────┘
                           │                    1520
                           ▼
                  ╱────────────────╲
                 ╱  DOES DIFFERENCE  ╲         No
                ⟨  BETWEEN SENSING    ⟩───────────┐
                 ╲ LINE GROUP DATA   ╱            │
                  ╲ EXCEED PRESET   ╱             │
                   ╲   VALUE?      ╱              │
                    ╲────────────╱               │
                           │ Yes                 │
                           ▼                     │
       ┌───────────────────────────────────────────┐   │
       │ DERIVE CORRECTION VALUE BASED ON AVERAGE   │   │
       │ VALUE OF CORRECTION TARGET DATA AND        │─── 1530
       │ AVERAGE VALUE OF REMAINING DATA            │   │
       └───────────────────┬───────────────────────┘   │
                           │                     │
                           ▼                     │
       ┌───────────────────────────────────────────┐   │
       │ CORRECT DIFFERENCE BETWEEN SENSING LINE    │─── 1540
       │ GROUP DATA WITH CORRECTION VALUE           │   │
       └───────────────────┬───────────────────────┘   │
                           │                     │
                           ▼◄────────────────────┘
                         ┌───┐
                         │ A │
                         └───┘
```

FIG.15

Ⓐ

CALCULATE DEGREE OF PROXIMITY OF EACH BATTERY CELL BASED ON PLURALITY OF REFERENCE BATTERY CELLS —1600

IS DEGREE OF PROXIMITY LESS THAN REFERENCE VALUE BASED ON PLURALITY OF REFERENCE BATTERY CELLS? 1610

No

Yes

APPLY SAME WEIGHT TO CORRESPONDING BATTERY CELLS —1620

GENERATE TREND LINE OBTAINED BY EXCLUDING OUTLIER BASED ON CORRELATION BETWEEN VOLTAGE VALUE INCLUDED IN BATTERY DATA AND THE FEATURE VALUE —1630

DERIVE DISTANCE VALUE BETWEEN BATTERY CELL AND TREND LINE —1640

DETERMINE WHETHER BATTERY CELL IS ABNORMAL BASED ON DISTANCE VALUE —1650

END

FIG.16

## INTERNATIONAL SEARCH REPORT

| International application No. |
|---|
| **PCT/KR2025/007015** |

**A. CLASSIFICATION OF SUBJECT MATTER**

**G01R 31/396**(2019.01)i; **G01R 31/382**(2019.01)i; **G01R 31/374**(2019.01)i; **G01R 31/36**(2006.01)i; **G06F 18/10**(2023.01)i; **G06N 20/00**(2019.01)i; **G01R 31/3835**(2019.01)i

According to International Patent Classification (IPC) or to both national classification and IPC

**B. FIELDS SEARCHED**

Minimum documentation searched (classification system followed by classification symbols)

G01R 31/396(2019.01); B60L 3/00(2006.01); G01R 31/36(2006.01); G01R 31/364(2019.01); G01R 31/367(2019.01); G01R 31/374(2019.01); G01R 31/3835(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 전처리(preprocessing), 센싱선(sensing line), 보정(calibration)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2021-0080069 A (LG ENERGY SOLUTION, LTD.) 30 June 2021 (2021-06-30) paragraphs [0017]-[0074]; claims 1-7; and figures 1-11 | 1-2,7-13,18-22 |
| A | | 3-6,14-17 |
| Y | KR 10-2022-0045701 A (LG ENERGY SOLUTION, LTD.) 13 April 2022 (2022-04-13) paragraphs [0062]-[0068]; and figures 1-5, 8 | 1-2,7-13,18-22 |
| Y | KR 10-2024-0000294 A (LG ENERGY SOLUTION, LTD.) 02 January 2024 (2024-01-02) paragraphs [0050]-[0066]; and figures 1-5 | 7-9,18-20 |
| A | WO 2016-158396 A1 (HITACHI AUTOMOTIVE SYSTEMS, LTD.) 06 October 2016 (2016-10-06) paragraphs [0012]-[0099]; claims 1-11; and figures 1-26 | 1-22 |
| A | JP 2020-106315 A (TOYOTA MOTOR CORPORATION) 09 July 2020 (2020-07-09) paragraphs [0023]-[0077]; claims 1-7; and figures 1-12 | 1-22 |

☐ Further documents are listed in the continuation of Box C.    ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **21 August 2025** | **21 August 2025** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/007015**

| Patent document cited in search report | | | Publication date (day/month/year) | Patent family member(s) | | | Publication date (day/month/year) |
|---|---|---|---|---|---|---|---|
| KR | 10-2021-0080069 | A | 30 June 2021 | EP | 3992648 | A1 | 04 May 2022 |
| | | | | EP | 3992648 | A4 | 05 October 2022 |
| | | | | EP | 3992648 | B1 | 29 January 2025 |
| | | | | ES | 3013296 | T3 | 11 April 2025 |
| | | | | HU | E070292 | T2 | 28 May 2025 |
| | | | | JP | 2022-545033 | A | 24 October 2022 |
| | | | | JP | 7384529 | B2 | 21 November 2023 |
| | | | | US | 12044747 | B2 | 23 July 2024 |
| | | | | US | 2022-0276319 | A1 | 01 September 2022 |
| | | | | WO | 2021-125676 | A1 | 24 June 2021 |
| KR | 10-2022-0045701 | A | 13 April 2022 | CN | 115004046 | A | 02 September 2022 |
| | | | | EP | 4080230 | A1 | 26 October 2022 |
| | | | | EP | 4080230 | A4 | 14 June 2023 |
| | | | | EP | 4080230 | B1 | 30 July 2025 |
| | | | | JP | 2023-508004 | A | 28 February 2023 |
| | | | | JP | 7548512 | B2 | 10 September 2024 |
| | | | | US | 12111365 | B2 | 08 October 2024 |
| | | | | US | 2023-0042107 | A1 | 09 February 2023 |
| | | | | WO | 2022-075636 | A1 | 14 April 2022 |
| KR | 10-2024-0000294 | A | 02 January 2024 | None | | | |
| WO | 2016-158396 | A1 | 06 October 2016 | CN | 107533109 | A | 02 January 2018 |
| | | | | CN | 107533109 | B | 04 September 2020 |
| | | | | EP | 3279679 | A1 | 07 February 2018 |
| | | | | EP | 3279679 | A4 | 31 October 2018 |
| | | | | EP | 3279679 | B1 | 29 June 2022 |
| | | | | JP | 6496810 | B2 | 10 April 2019 |
| | | | | US | 11124072 | B2 | 21 September 2021 |
| | | | | US | 2018-0074129 | A1 | 15 March 2018 |
| JP | 2020-106315 | A | 09 July 2020 | CN | 111381168 | A | 07 July 2020 |
| | | | | CN | 111381168 | B | 28 June 2022 |
| | | | | JP | 7153196 | B2 | 14 October 2022 |
| | | | | US | 11221372 | B2 | 11 January 2022 |
| | | | | US | 2020-0209319 | A1 | 02 July 2020 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240067307
- KR 1020250049564